# EUROPEAN PATENT SPECIFICATION

(11) **EP 0 929 904 B1**
(45) Date of publication and mention of the grant of the patent: **20.12.2000**
(21) Application number: 97931980.3
(22) Date of filing: 04.08.1997
(51) Int. Cl.: H01F 7/04, B66C 1/04, H01F 7/02

(54) **LIFTER WITH ELECTROPERMANENT MAGNETS PROVIDED WITH A SAFETY DEVICE**
HEBER MIT ELEKTROPERMANENTMAGNETEN MIT EINER SICHERHEITSVORRICHTUNG
ELECTRO-AIMANT PERMANENT DE LEVAGE A DISPOSITIF DE SECURITE

(43) Date of publication of application: 21.07.1999
(73) Proprietor: Railfix N.V., Curacao (AN)
(72) Inventor: ELIAS, Gregory, E., Curacao (AN)
(74) Representative: Pizzoli, Antonio
(86) International application number: PCT/IB97/00960
(87) International publication number: WO 99/08293

(56) References cited:
- WO-A-97/03911
- GB-A- 2 043 354
- US-A- 4 965 695
- PATENT ABSTRACTS OF JAPAN vol. 017, no. 201 (M-1399), 20 April 1993 & JP 04 345498 A (FUJI JIKOU KK), 1 December 1992,

## Description

The present invention relates to magnet lifters, and particularly to a lifter with electropermanent magnets provided with a safety device for controlling their working point.

As it is known, lifters are divided into three classes depending on the type of used magnets, i.e. permanent magnets, electropermanent magnets and electromagnets. Each lifter type has its own advantages and drawbacks.

The lifters with permanent magnets have the advantage of an almost negligible power consumption and of a produced magnetic force which is reliably constant and independent of outer supply sources. On the other hand, it is not possible to increase the magnetic force if necessary and the magnets are exceedingly bulky for lifting heavy loads. Furthermore, the load detachment requires the application of a considerable mechanical power amount in order to reduce the magnetic force to a value smaller than the load weight. Alternatively, the magnets are to be made movable so as to be moved away from the load, thus decreasing the magnetic attraction.

On the contrary, in the lifters with electromagnets it is possible to freely vary the magnetic force by simply adjusting the current flowing in the windings which generate the magnetic field. However, any breakdown, even if very short, of the power supply immediately cancels the magnetic force and thus causes the load detachment. It is therefore evident that safety systems ensuring the supply continuity are essential.

The lifters with electropermanent magnets substantially combine the advantages of the two aforementioned lifter types. This is due to the use of a permanent magnet of the reversible type, i.e. a magnet wherein the polarity is easily reversible through the application of an electric impulse. The reversible magnet thus generates an adjustable flux which also can direct the flux of a conventional permanent magnet combined therewith. It is thus possible to short-circuit the two magnets when the lifter is to be deactivated, or arrange them in parallel for activating the lifter. Since just an electric impulse but not a continuous supply is needed for reversing the reversible magnet, the safety problems affecting electromagnets are overcome. At the same time, even though permanent magnets are used, it is possible to vary the magnetic force within some limits, and the load detachment is easy to carry out with a minimum power consumption and without complex structures for moving the magnets.

However, the electropermanent magnets, with respect to the other two types of magnets, have a drawback in the working instability due to the particular magnetization curve of the reversible magnet. In fact the reversible magnets are usually made of an aluminum-nickel-cobalt (alnico) alloy having an hysteresis characterized in that a high induction corresponds to a reduced coercive force. This characteristic allows to direct the magnetic flux in the permanent magnet forming the electropermanent magnet.

However, the magnetization curve has a "knee" beyond which the behavior of the reversible magnet is still linear, but much more sloped than in the first region. This involves great induction variations corresponding to small coercive force variations. Practically this means that the lifters with electropermanent magnets are greatly affected by the dynamics of the lifted material. It is in fact known that the oscillations of the plates lifted by such a unit involve a variation of the air gap, and accordingly a variation of the total reluctance of the magnetic circuit, which may shift the working point of the magnetic masses of the lifter below said "knee". This dynamics is affected even by little shifts of the lifted material and thus slight bendings or hardly detectable curvings are enough to cause a considerable variation of the magnetomotive force thereby making the lifting system very unstable.

WO-97/03911 which describes a lifter according to the preamble of claim 1, and GB-A-2043354 disclose lifters having a system for measuring the magnetic force which is the same for any type of magnets. This measuring system only serves to calculate the safety operative factor by comparing the generated magnetic force with the weight of the load to be lifted This is carried out by arranging measuring means close to the pole pieces contacting the load, so as to quite accurately measure the total flux linked with the load. Such a measure obviously gives no precise indication about the working point, so it is not capable of signaling the risk resulting from the instability, if any, of the reversible magnet.

It is an object of the present invention to provide a lifter with electropermanent magnets provided with a safety device which allows to control the instability, if any, of the lifting unit depending on the actual working conditions.

Such an object is achieved by means of a lifter provided with a sensor capable of measuring the only contribution of the reversible magnet and accordingly its working point.

The main advantage of the present lifter is thus to ensure the highest operating safety by indicating not only the total safety factor but also the approach of the instability condition.

Another advantage of the lifter according to the present invention is that, by suitably combining the data supplied by the sensor measuring the reversible magnet flux with the data supplied by the sensor measuring the total magnetic flux, it is possible to compensate the reading error of the latter due to the magnetic dispersions caused by the air gap between the active polarities and the load, said error being proportional to the air gap size.

Further advantages and features of the lifter according to the present invention will be evident to those skilled in the art from the following detailed description of an embodiment thereof with reference to the attached drawings, wherein:
- Fig. 1 is a front diagrammatic view, with the left half in section, of a lifter according to the invention in the non-working phase;
- Fig. 2 is a partial view in horizontal section of a symmetrical half of the lifter of Fig. 1;
- Fig. 3 is a diagram comprising the magnetization curves of the reversible magnet and of the permanent magnet; and
- Fig. 4 is a view of the lifter of Fig. 1, in the load conveying phase.

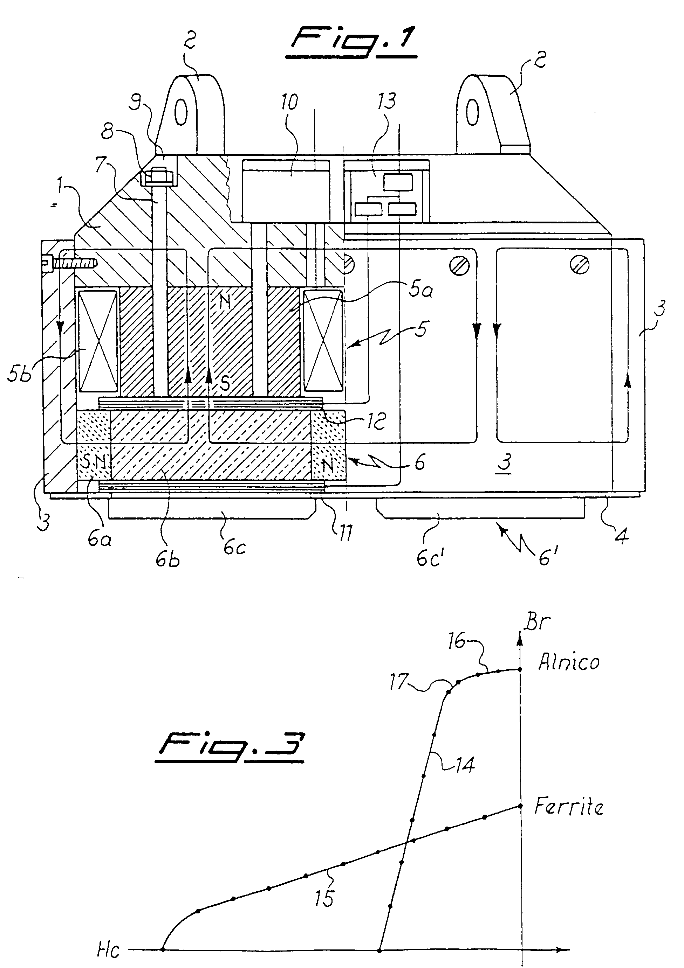

Referring to Fig. 1, the lifter with electropermanent magnets according to the present invention in a known way comprises an outer supporting structure, a plurality of magnets and an adjustment and control unit.

The supporting structure consists in an upper block 1, provided with joints 2 for the fastening to lifting means, e.g. a crane, four sides 3 and a closing base plate 4. Obviously such a structure is made of highly magnetically conductive materials in order to minimize the reluctance of the magnetic circuit.

Each electropermanent magnet is formed by a reversible magnet 5 and a permanent magnet 6 arranged one above the other respectively. The polarities of reversible magnet 5 are arranged on the horizontal sides of a core 5a, made of alnico, around which a commuting coil 5b is arranged for controlling the pole reversal. While the lifter is not working, as shown in Fig. 1, the north pole (N) is on the upper side and the south pole (S) in on the lower side.

Permanent magnet 6 comprises a plurality of ferrite blocks 6a arranged along the lateral sides of an iron core 6b. This core 6b is fastened to block 1 through a plurality of bars 7 passing through the alnico core 5a and constrained by nuts 8 into suitable seats 9. Thus, also permanent magnet 5 is fastened under block 1. Core 6b extends downwards in a pole piece 6c, protruding from plate 4 and intended to contact the load to be lifted.

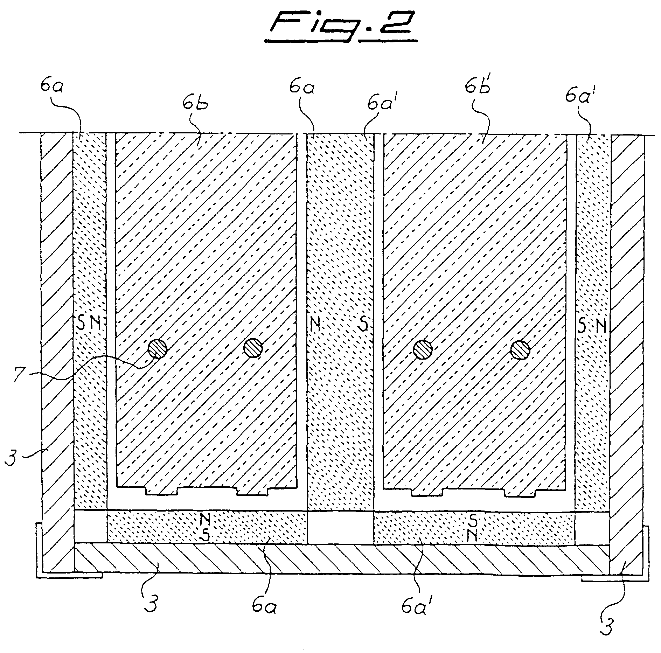

The arrangement of the polarities of ferrite blocks 6a is clearly shown in Fig. 2, wherein on all sides the north pole is facing core 6b and the south pole is facing outwards.

The above description relates to magnets 5, 6, arranged on the left of the lifter shown in Fig. 1, i.e. to those visible in the half section. For closing of the magnetic circuits indicated by the arrows, another electropermanent magnet is suitably arranged with the reversed polarities in the right half of the lifter. In other words, there is a second reversible magnet 6' having its south pole on the upper side and its north pole on the lower side. Second permanent magnet 6' likewise comprises a plurality of ferrite blocks 6a' arranged with their south poles facing core 6b' and their north poles facing outwards (see Fig. 2).

This magnet arrangement induces a magnetic field comprising three sheaves of flux lines substantially oriented in the direction indicated by the arrows of Fig. 1. The middle sheaf of these flux lines passes through the two reversible magnets 5, 5', the two cores 6b, 6b' and ferrite blocks 6a, 6a' arranged therebetween, besides some portions of the outer supporting structure. The two side sheaves of flux lines pass instead through only one of reversible magnets 5, 5', one of cores 6b, 6b' and ferrite blocks 6a, 6a' arranged between one of these cores and sides 3. Such flux lines, being linked together, flow inside the lifter, so that a ferromagnetic load, arranged close to pole pieces 6c, 6c', would not be attracted by the lifter.

The adjustment and control circuits comprise at least a control circuit 10 of commuting coil 5b, a first magnetic sensor 11 and a second magnetic sensor 12 respectively arranged above and under ferrite blocks 6a, as well as at least a safety device 13 for processing the signals coming from said sensors 11 and 12. Lower magnetic sensor 11 consists for instance of a coil having its loops surrounding the base of core 6b in order to measure the flux linked with the load. Upper magnetic sensor 12, consisting for instance of a further coil having its loops surrounding the upper portion of core 6b, is the innovative aspect of the present lifter as it allows to measure the only contribution of reversible magnet 5, as it will be hereinafter explained.

Although a single pair of sensors 11 and 12 is enough to control the working of a pole pair of an electropermanent magnet, each electropermanent magnet is preferably provided with its own pair of sensors in order to achieve a greater measure accuracy. Thus, a lower coil and an upper coil (not shown in figure) are also arranged around core 6b' of the magnet, both connected to safety device 13, so as to reduce the measure error by averaging the readings of the two pairs of coils.

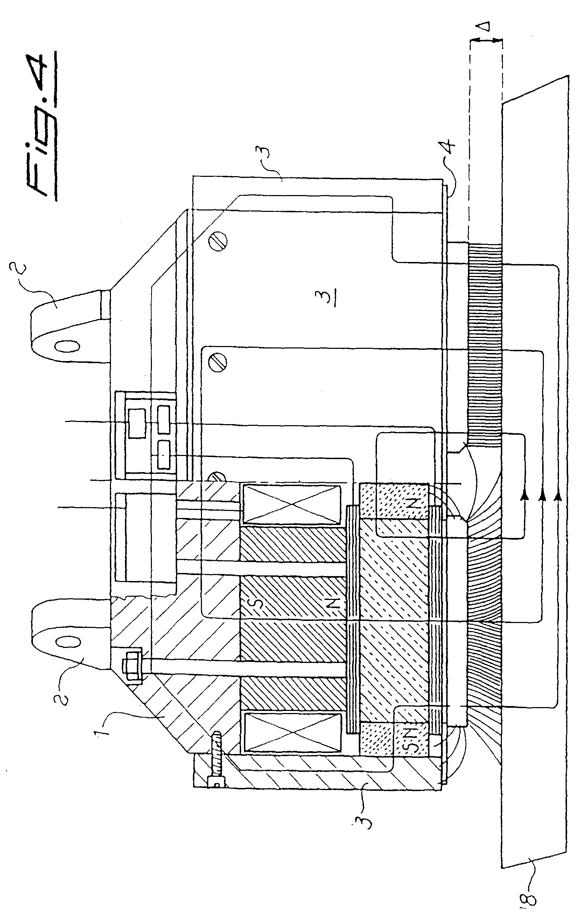

Referring to Fig. 3, the magnetization curve showing the ratio between residual induction Br and coercive field intensity Hc has two different characteristics depending on the magnet type of the lifter. In particular, magnetization curve 14 of reversible magnets 5, 5', unlike curve 15 of permanent magnets 6, 6', has a quite short linear segment 16 between "knee" 17 and the axis of residual induction Br corresponding to a zero level of coercive field intensity Hc. Beyond "knee" 17, magnetization curve 14 is highly sloped and shows hysteresis phenomena, whereby, if the working point of the lifter accidentally comes in that region, its lifting force is unstable, since residual induction Br swiftly varies upon slight variations of intensity Hc and moreover there is no bijection between these two quantities owing to the magnetic hysteresis.

Referring now also to Fig. 4, a ferromagnetic load 18 may be attracted by the lifter according to the present invention by placing it close to pole pieces 6c, 6c' and by reversing the polarities of reversible magnets 5, 5' through the respective commuting coils. Thus the magnetic flux lines are no longer linked with those of permanent magnets 6a, 6a', as shown in Fig. 1. Instead, all the flux lines pass through load 18, since, thanks to the particular magnet arrangement, the magnetic circuit is forced to come out of pole piece 6c and go back into pole piece 6c'. Also in this case a magnetic field is induced comprising three sheaves of flux lines, which are however substantially oriented in the direction indicated by the arrows in Fig. 4 and thus being concentric.

In particular, it should be noted that the flux lines passing through reversible magnets 5, 5' do not pass through ferrite blocks 6a, 6a', thus not being affected by the magnetic field generated therefrom Therefore sensors 12 detect the intensity of the magnetic flux generated only by the reversible magnets, whereas sensors 11 also detect the contribution given by ferrite blocks 6a, 6a'.

Safety device 13 in the present embodiment comprises an electronic circuit controlled by a microprocessor receiving as input the signals transmitted by sensors 11 and 12 and subsequently amplified and converted in digital form. Device 13 processes the signals of sensors 11 and 12 in order to respectively obtain the total magnetic force of the electropermanent magnets and the working point of reversible magnets 5, 5' on curve 14. By comparing such values with each other, device 13 compensates the difference between the magnetic flux measured by sensors 11 and the magnetic flux actually passing through load 18. Such a difference results from the dispersions ofthe magnetic flux due to the air gap Δ, i.e. to the variations of the distance between load 18 and pole pieces 6c, 6c'. In Figure 4 on the left the flux lines are shown through the air gap A (enlarged) under real conditions, i.e. with the dispersion effects, and on the right the same flux lines under ideal conditions, i.e. without the dispersion effects.

Thanks to sensors 12 arranged over the permanent magnets, device 13 determines the working point of reversible magnets 5, 5' on curve 14 of Figure 3. and accordingly calculates in sequence the size of air gap A, the value of induction Br, the magnetic linkage with load 18 and finally the effective magnetic force acting on the latter. The software of safety device 13 thus comprises a specific algorithm capable of automatically correct the readings of sensors 11 so as to eliminate the errors due to the dispersed magnetic fluxes owing to the air gap Δ.

Should the effective magnetic force operating on load 18 be insufficient for its lifting, or should the working point of reversible magnets 5, 5' not be on linear segment 16, device 13 would provide for immediately signaling the risk situation to the operators by means of acoustic or optical alarm signals or the like.

Obviously the above described and illustrated embodiment of the lifter according to the invention is only an example susceptible of various modifications. In particular, the material the magnets are made of may vary depending on the lifter requirements. For example, the permanent magnets may be made of neodymium or other rare earths.

Likewise obviously, in another embodiment of the lifter according to the present invention, magnetic sensors 11 and 12 may not comprise coils, but other type of sensors, e.g. Hall effect sensors.

## Claims

1. A lifter comprising at least a reversible magnet (5, 5') arranged over at least a magnet (6, 6') provided with a permanent magnet (6a) arranged with its polarities oriented along an horizontal axis on the sides of at least a ferromagnetic core (6b, 6b') suitable to contact the load (18) to be lifted, and at least a magnetic sensor (11) arranged close to the base (6c, 6c') of said ferromagnetic core, as well as a further magnetic sensor (12) and a safety device (13) and for processing the signals transmitted by said magnetic sensors (11, 12) and obtaining the working point of the lifter on the magnetization curve (14) of the reversible magnet (5, 5'), characterized in that the polarities of the reversible magnet (5, 5') are arranged along a vertical axis, said magnet (6, 6') is provided with at least another permanent magnet (6a'), said permanent magnets (6a, 6a') being arranged with their polarities oriented along an horizontal axis on the sides of said ferromagnetic core (6b, 6b'), and in that said further magnetic sensor (12) is arranged above said permanent magnets (6a, 6a') so as to measure substantially the only magnetic flux passing through the reversible magnet (5, 5').

2. A lifter according to the previous claim, characterized in that it comprises a pair of reversible magnets (5, 5'), each being arranged with its polarities oriented mutually reversed along a vertical axis over a magnet (6, 6') provided with a plurality of permanent magnets (6a, 6a') arranged with their polarities oriented along a horizontal axis on the sides of a ferromagnetic core (6b, 6b'), wherein the magnetic fluxes induced by the reversible magnets (5, 5') are linked together.

3. A lifter according to the previous claim, characterized in that it comprises a magnetic sensor (11) arranged at the base of each of two ferromagnetic cores (6b, 6b') and a further magnetic sensor (12) arranged between each of the two reversible magnets (5, 5') and the permanent magnets (6a, 6a') thereto associated.

4. A lifter according to any of the previous claims, characterized in that at least one of the reversible magnets (5, 5') is made of a metallic alloy comprising aluminum, nickel and cobalt.

5. A lifter according to any of the previous claims, characterized in that at least one of the magnetic sensors (11, 12) comprises a coil having its loops surrounding a portion of said ferromagnetic cores (6b, 6b').

6. A lifter according to any of claims 1 to 4, characterized in that at least one of the magnetic sensors (11, 12) comprises an Hall effect sensor.

7. A lifter according to any of the previous claims, characterized in that the reversible magnets (5, 5') and the permanent magnets (6a, 6a') are housed inside a highly magnetically conductive structure (1, 3, 4), having the ferromagnetic cores (6b, 6b') partially protruding from its base.

8. A lifter according to any of the previous claims, characterized in that the safety device (13) comprises an electronic circuit controlled by a microprocessor receiving as input the signals transmitted by the magnetic sensors (11, 12) and converted in digital form.

9. A lifter according to the previous claim, characterized in that the safety device (13) calculates the magnetic flux passing through the lifted load (18) depending on the difference of values detected through the magnetic sensors (11, 12).

10. A lifter according to the previous claim, characterized in that the safety device (13) comprises alarm means being automatically activated if the working point of the lifter on the magnetization curve (14) of the reversible magnets (5, 5') is not in the linear segment (16) between the knee (17) and the axis of the residual induction (Br) corresponding to a zero level of the coercive field intensity (Hc).

## Patentansprüche

1. Ein Heber mit wenigstens einem reversierbaren Magneten (5, 5'), der über wenigstens einem Magneten (6,6') angeordnet ist, der einen längs einer waagerechten Achse polarisierte Permanentmagnete (6a) an den Seiten wenigstens eines ferromagnetischen Kerns (6b, 6b') aufweist, der geeignet ist, mit der anzuhebenden Last (18) in Berührung zu kommen, und mit wenigstens einem Magnetsensor (11), der in der Nähe der Basis (6c, 6c') des ferromagnetischen Kerns angeordnet ist, sowie mit einem weiteren Magnetsensor (12) und einer Sicherheitsvorrichtung (13) zum Verarbeiten der von den Magnetsensoren (11, 12) übermittelten Signale und zur Ermittlung des Arbeitspunktes des Hebers auf der Magnetisierungskurve (14) des reversierbaren Magneten (5, 5'), dadurch gekennzeichnet, daß der reversierbare Magnet (5, 5') längs einer vertikalen Achse gepolt ist, der Magnet (6, 6') wenigstens einen weiteren Permanentmagneten (6a') aufweist, wobei diese Permanentmagnete (6a, 6a') an den Seiten des ferromagnetischen Kerns (6b, 6b') längs einer waagerechten Achse gepolt sind, und daß der weitere Magnetsensor (12) über den Permanentmagneten (6a,6a') angeordnet ist, um im wesentlichen nur den magnetischen Fluß zu messen, der durch den reversierbaren Magneten (5, 5') hindurchgeht.

2. Ein Heber nach dem vorstehenden Anspruch, dadurch gekennzeichnet, daß er zwei reversierbare Magnet (5, 5') aufweist, die längs einer vertikalen Achse entgegengesetzt zueinander gepolt sind, über einem Magneten (6, 6') mit mehreren Permanentmagneten (6a, 6a'), die an den Seiten eines ferromagnetischen Kerns (6b, 6b') längs einer waagerechten Achse gepolt sind, wobei die von den reversierbaren Magneten (5, 5') erzeugten magnetischen Flüsse miteinander verkettet sind.

3. Ein Heber nach dem vorstehenden Anspruch, dadurch gekennzeichnet, daß er einen an der Basis eines jeden von zwei ferromagnetischen Kernen (6b, 6b') angeordneten Magnetsensor (11) und einen weiteren Magnetsensor (12) aufweist, der zwischen jedem der beiden reversierbaren Magnete (5, 5') und den ihnen zugeordneten Permanentmagneten (6a, 6a') angeordnet ist.

4. Ein Heber nach einem der vorstehenden Ansprüche, dadurch gekennzeichnet, daß wenigstens einer der reversierbaren Magnete (5, 5') aus einer Metallegierung hergestellt ist, die Aluminium, Nickel und Kobalt enthält.

5. Ein Heber nach einem der vorstehenden Ansprüche, dadurch gekennzeichnet, das wenigstens einer der Magnetsensoren (11, 12) eine Spule aufweist, deren Windungen einen Teil der ferromagnetischen Kerne (6b, 6b') umgeben.

6. Ein Heber nach einem der Ansprüche 1 bis 4, dadurch gekennzeichnet, daß wenigstens einer der Magnetsensoren (11, 12) einen Halleffekt-Sensor aufweist.

7. Ein Heber nach einem der vorstehenden Ansprüche, dadurch gekennzeichnet, daß die reversierbaren Magnete (5, 5') und die Permanentmagnete (6a, 6a') im Inneren einer magnetisch hochleitfähigen Struktur (1, 3, 4) untergebracht sind, von deren Basis die ferromagnetischen Kerne (6b, 6b') teilweise vorstehen.

8. Ein Heber nach einem der vorstehenden Ansprüche, dadurch gekennzeichnet, daß die Sicherheitsvorrichtung (13) eine elektronische Schaltung aufweist, die durch einen Mikroprozessor gesteuert ist, der als Eingangssignale die von den Magnetsensoren (11, 12) übermittelten und in digitale Form umgewandelten Signale aufnimmt.

9. Ein Heber nach dem vorstehenden Anspruch, dadurch gekennzeichnet, daß die Sicherheitsvorrichtung (13) den durch die angehobene Last (18) gehenden magnetischen Fluß berechnet, der von der Differenz der durch die Magnetsensoren (11, 12) erfaßten Werte abhängig ist.

10. Ein Heber nach dem vorstehenden Anspruch, dadurch gekennzeichnet, daß die Sicherheitsvorrichtung (13) eine Alarmeinrichtung aufweist, die automatisch aktiviert wird, wenn der Arbeitspunkt des Hebers auf der Magnetisierungskurve (14) der reversierbaren Magnete (5, 5') nicht in dem linearen Segment (16) zwischen dem Knie (17) und der Achse der Rest-Induktion (Br) liegt, die einem Nullpegel der Koerzitivfeldstärke (Hc) entspricht.

## Revendications

1. Un organe de levage comprenant au moins un aimant réversible (5, 5') disposé sur au moins un aimant (6, 6') muni d'un aimant permanent (6a) disposé avec ses polarités orientées le long d'un axe horizontal sur les côtés d'au moins un noyau ferromagnétique (6b, 6b') approprié pour venir en contact de la charge (18) à soulever, et au moins un capteur magnétique (11) disposé près de la base (6c, 6c') dudit noyau ferromagnétique, ainsi qu'un capteur magnétique supplémentaire (12) et un dispositif de sécurité (13) et pour traiter les signaux émis par lesdits capteurs magnétiques (11, 12) et obtenir le point de fonctionnement de l'organe de levage sur la courbe de magnétisation (14) de l'aimant réversible (5, 5'), caractérisé en ce que les polarités de l'aimant réversible (5, 5') sont disposées le long d'un axe vertical, ledit aimant (6, 6') est muni d'au moins un autre aimant permanent ( 6a'), lesdits aimants permanents (6a, 6a') étant disposés avec leurs polarités orientées le long d'un axe horizontal sur les côtés dudit noyau ferromagnétique (6b, 6b'), et en ce que ledit capteur magnétique supplémentaire (12) est disposé au-dessus desdits aimants permanents (6a, 6a') de manière à ne mesurer pratiquement que le seul flux magnétique passant à travers l'aimant réversible (5, 5').

2. Un organe de levage selon la revendication précédente, caractérisé en ce qu'il comprend une paire d'aimants réversibles (5, 5'), chacun étant disposé avec ses polarités orientées mutuellement de manière inverse le long d'un axe vertical sur un aimant (6, 6') muni d'une pluralité d'aimants permanents (6a, 6a') disposés avec leurs polarités orientées le long d'un axe horizontal sur les côtés d'un noyau ferromagnétique (6b, 6b'), dans lequel les flux magnétiques induits par les aimants réversibles (5, 5') sont reliés entre eux.

3. Un organe de levage selon la revendication précédente, caractérisé en ce qu'il comprend un capteur magnétique (11) disposé sur la base de chacun des deux noyaux ferromagnétiques (6b, 6b') et un capteur magnétique supplémentaire (12) disposé entre chacun des deux aimants réversibles (5, 5') et les aimants permanents (6a, 6a') associés à ceux-ci.

4. Un organe de levage selon une quelconque des revendications précédentes, caractérisé en ce qu'au moins un des aimants réversibles (5, 5') est réalisé en un alliage métallique comprenant de l'aluminium, du nickel et du cobalt.

5. Un organe de levage selon une quelconque des revendications précédentes, caractérisé en qu'au moins un des capteurs magnétiques (11, 12) comprend une bobine présentant ses boucles entourant une partie desdits noyaux ferromagnétiques (6b, 6b').

6. Un organe de levage selon une quelconque des revendications 1 à 4, caractérisé en ce qu'au moins un des capteurs magnétiques (11, 12) comprend un capteur à effet Hall.

7. Un organe de levage selon une quelconque des revendications précédentes, caractérisé en ce que les aimants réversibles (5, 5') et les aimants permanents (6a, 6a') sont logés à l'intérieur d'une structure à forte conduction magnétique (1, 3, 4), en ayant les noyaux ferromagnétiques (6b, 6b') faisant partiellement saillie de sa base.

8. Un organe de levage selon une quelconque des revendications précédentes, caractérisé en ce que le dispositif de sécurité (13) comprend un circuit électronique commandé par un micro-processeur recevant à son entrée les signaux émis par les capteurs magnétiques (11, 12) et convertis sous forme numérique.

9. Un organe de levage selon la revendication précédente, caractérisé en ce que le dispositif de sécurité (13) calcule le flux magnétique passant à travers la charge soulevée (18) selon la différence des valeurs détectées par les capteurs magnétiques (11, 12).

10. Un organe de levage selon la revendication précédente, caractérisé en ce que le dispositif de sécurité (13) comprend des moyens d'alarme qui sont automatiquement activés si le point de fonctionnement de l'organe de levage sur la courbe de magnétisation (14) des aimants réversibles (5, 5') ne se trouve pas sur un segment linéaire (16) entre le coude (17) et l'axe de l'induction résiduelle (Br) correspondant à un niveau nul de l'intensité de champ coercitif (Hc).
